# EUROPEAN PATENT APPLICATION

(11) **EP 0 896 365 A1**
(43) Date of publication of application: **10.02.1999**
(21) Application number: 98306011.2
(22) Date of filing: 28.07.1998
(51) Int. Cl.: H01L 21/336, H01L 21/60

(54) **Method of manufactruing MOSFETs with self-aligned silicide contacts**

(30) Priority: 07.08.1997 US 907406
(71) Applicant: LUCENT TECHNOLOGIES INC., Murray Hill, New Jersey 07974-0636 (US)
(72) Inventor: Hillenius, Steven James, Summit, New Jersey 07901 (US); Liu, Chun-Ting, Berkeley Heights, New Jersey 07922 (US)
(74) Representative: Johnston, Kenneth Graham

(57) **Abstract**

In accordance with the invention, a MOSFET is fabricated with a double spacer structure between the gate and the source and drain regions. The double spacer region provides a self-aligned silicide contact process with relaxed requirements for lithographic minimum features and misalignment tolerance.

## Description

### FIELD OF THE INVENTION

This invention relates to methods of making MOS field effect transistors (MOSFETS) and, in particular, to an improved method of making MOSFETS with self-aligned silicide contacts to source and drain.

### BACKGROUND OF THE INVENTION

Field effect devices, such as field effect transistors, are fundamental components in modern electronics. They are basic components in most digital and many analog circuits, including circuits for data processing and telecommunications. Indeed it has been surmised that field effect transistors are among the most numerous of human-made objects.

A typical MOS field effect transistor comprises a silicon surface including a controllable-conductivity path, called a channel, disposed between a source and a drain. A gate electrode (the "metal" of MOS) is formed on a thin film of dielectric (the "oxide" of MOS) overlying the channel (the "silicon"). For example, the source and the drain can be n-type regions of silicon and the channel can be a p-type region connecting them. The gate electrode can be a conductively-doped polysilicon layer formed on a thin layer of silicon oxide dielectric overlying the channel.

In a normally-off transistor, if no voltage is applied to the gate, current cannot flow from the source to the channel or from the channel to the drain. However if a sufficient positive voltage is applied to the gate, electrons are induced into the channel region, thereby creating a continuous n-type conductive path between the source and the drain. Alternatively the channel can be a n-type region between a p-type source and a p-type drain. A negative voltage at the gate will induce a continuous p-type path between the source and the drain.

Historically, the development of self-aligned processes for making field effect devices has contributed greatly to the miniaturization of integrated circuits. One major contributor to miniaturization was the development of the self-aligned silicon gate process wherein the polysilicon gate is used as a mask protecting the channel region when the source and drain regions are formed.

A more recent advance is the development of the self-aligned silicide contact process wherein metal silicides forming selectively on exposed regions of silicon are used to enhance conductivity and reduce the source/drain junction areas. This reduces junction capacitance and improves circuit performance.

One difficulty that has arisen in the self-aligned silicide contact process is the difficulty in electrically separating the source and drain regions. The source, gate and drain constitute three closely spaced regions of silicon with the gate width optimally constituting the smallest dimension definable by available lithography. To separate the source and drain in the silicided structure, any conductive layer between the two must be cut in a very narrow region not much larger than the gate width, an obviously critical lithographic step.

It is common practice in fabricating MOS field effect devices to form the source, gate and drain on a silicon substrate and then to form a pair of dielectric side wall spacers on either side of the gate. The spacers are typically formed by deposition of a thick oxide layer followed by back-etch. Further details of this process are described, for example, in C.Y. Chang and S.M. Sze, ULSI Technology, Ch. 9 (McGraw-Hill, 1996), which is incorporated herein by reference. However these sidewall spacers are typically very steep and do little to relax the criticality in cutting conductive layers over the gate. Accordingly there is a need for an improved method for making MOSFETS with self-aligned silicide contacts.

### SUMMARY OF THE INVENTION

In accordance with the invention, a MOSFET is fabricated with a double spacer structure between the gate and the source and drain regions. The double spacer region provides relaxed requirements for lithographic minimum features and misalignment tolerance.

### BRIEF DESCRIPTION OF THE DRAWINGS

The advantages, nature and various additional features of the invention will appear more fully upon consideration of the illustrative embodiments now to be described in detail in connection with the accompanying drawings:

In the drawings:
Fig. 1 is a flow diagram illustrating the steps in fabricating a MOS field effect device with self-aligned silicide contacts; and
Figs. 2A-2D are schematic cross sections of the device at various stages of the process of Fig. 1.

It is to be understood that these drawings are for purposes of illustrating the concepts of the invention and are not to scale.

### DETAILED DESCRIPTION

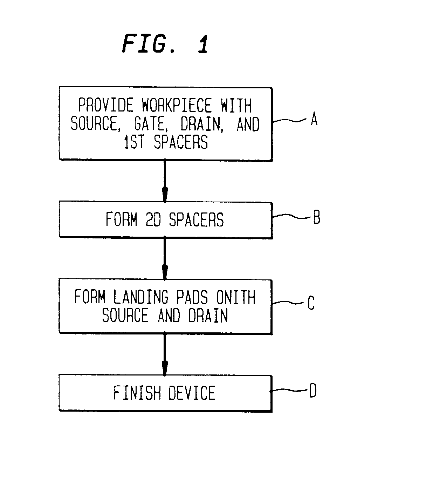

Referring to the drawings, Fig. 1 is a schematic flow diagram of the steps in an improved self-aligned silicide contact process. The initial step, shown in block A, is to provide a workpiece comprising the source, gate and drain of a silicon-gate MOS field effect device, including a first pair of side wall spacers on either side of the silicon gate. Such a workpiece is conveniently and conventionally provided by processing a silicon wafer using the well-known self-aligned silicon gate process to form the source, gate and drain regions and using deposition and back-etching of thick oxide to form the side-wall spacers. See, for example, the aforementioned excerpt from Chang and Sze.

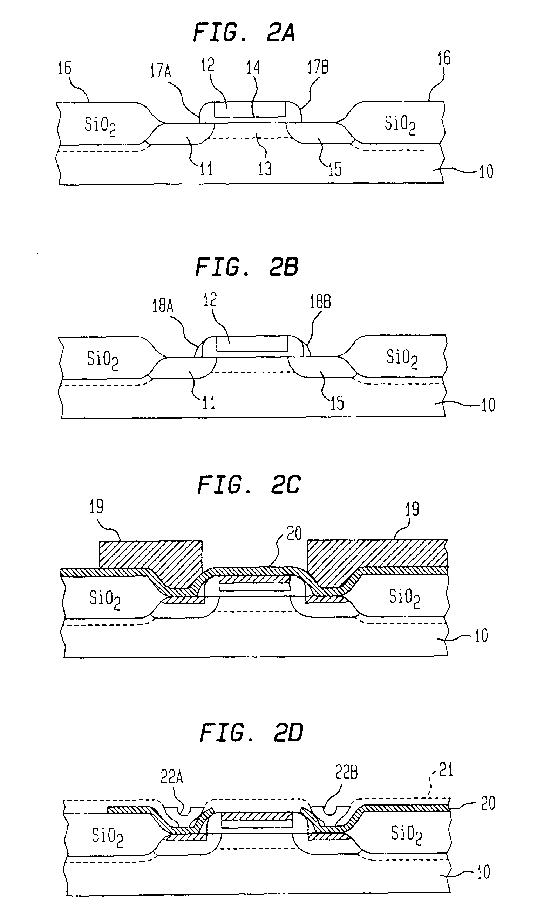

Fig. 2A illustrates the resulting workpiece, comprising a monocrystalline silicon substrate 10, a source 11, a polysilicon gate 12 separated from a channel region 13 by a thin gate dielectric 14, such as silicon oxide, and a drain 15. A relatively thick field oxide 16 substantially surrounds the device on the surface of the substrate 10, and a first pair of sidewall spacers 17A and 17B, separate the gate from the surfaces of the source and drain regions.

The next step, shown in block B, is to form a second pair of sidewall spacers as by depositing a thin layer of dielectric over the exposed gate and source/drain regions and etching back the layer to remove it from the planar surfaces while leaving second spacers in the step region near the first spacers. Advantageously the dielectric can be SiO₂ or Si₃N₄. Preferred thickness ofthe dielectric is in the range 50 - 150nm. SiO₂ or Si₃N₄ dielectrics can be conveniently deposited by liquid phase chemical vapor deposition (LPCVD) or PETEOS, respectively. Etching back can be by reactive ion etching (RIE) or wet chemical etching.

Fig. 2B illustrates the resulting structure with the second sidewall spacers 18A and 18B adjacent the first spacers. The presence of the second spacers both reduces the steepness of the sidewall topography and extends the width of the plateau region above the gate.

The third step (block C) is to form the source/drain landing pads. This involves depositing a metal layer on the exposed silicon regions, reacting the metal to form a conductive silicide and lithographically defining the source and drain landing pads. The preferred metal layer is a composite layer of Ti/TiN. Preferred thicknesses are Ti in the range 10 - 50nm and TiN in the range 10 - 50nm. The layers are preferably deposited by sputtering. The Ti is reacted with the silicon by a rapid thermal anneal at a temperature on the order of 800° C.

Fig. 2C shows the masking of the silicided workpiece by photo resist 19 for defining the landing pads. The critical region for this lithography is the region on the gate plateau where the metal 20 must be etched away over the gate and onto the spacers to electrically separate the source, the gate and the drain. Here the advantages produced by the second spacers 18A and 18B become clear. First, the minimum spacing is longer than the gate width, relaxing the lithographic requirements. Second, the misaligned tolerance is extended by the size of the second spacer, and third the vertical topography is less steep. This enlarges the sidewall angles, reduces the etch thickness on the sidewalls and thereby reduces defects.

The final step shown in block D is to finish the MOS field effect device. This can be done in the conventional manner to produce a device of the type shown in Fig. 2D wherein an insulating layer 21 is disposed over the source, gate and drain and separate aluminum contacts 22A, 22B extend through the insulator to contact silicided source and drain.

The invention will be more clearly understood upon consideration of the following specific example.

### Example

The method of Fig. 1 has been applied to the fabrication of 0.25µm CMOS circuits with the following process conditions. The physical length of the gate runners is 0.24µm, and the **first** oxide spacers surrounding the gate runners are 80 nm at the foot of the gate runners. Source, drain, and gate electrodes are implanted with 5X10¹⁵/cm² implant dose of arsenic and boron for the n-channel and p-channel devices, respectively. A thermal cycle of 1050°C for 10 seconds forms the desired doping profiles in those electrodes. At this point, a SiO₂ layer of 100 nm is deposited with LPCVD at 700°C and etched back to create the **second** spacers of ~ 75 nm at the foot of the gate runners. Consequently, the total distance between the edge of the electrode and the exposed source/drain areas is now 155 nm which is 55 nm larger than the lithography alignment of the 0.25µm generation. A Ti layer of 15nm is sputtered on the wafers, covered by a TiN layer of 25 nm also deposited with sputtering. A rapid thermal anneal step of 800°C for 30 seconds is used for the reaction of the Ti layer with the exposed Si surfaces. Photo resist is then used for the patterns of the TiN layer which is either dry etched or wet etched on the areas not covered by the photo resist. The etch step has a selectivity of more than 20:1 between TiN and TiSi₂. The unreacted Ti on areas originally covered by oxide, e.g., on the isolation areas, is also etched away during this etch step with the same etch rate as the TiN layer.

It is to be understood that the above-described embodiments are illustrative of only a few of the many possible specified embodiments which can represent applications of the principles of the invention. Numerous and varied other methods can be readily devised by those skilled in the art without departing from the spirit and scope of the invention.

## Claims

1. In the method of making a field effect transistor comprising the steps of forming on a surface of a semiconductor substrate a gate having sidewalls and a source and a drain, said source and drain separated by a channel, said gate overlying said channel and separated therefrom by a layer of dielectric material; forming a first pair of dielectric sidewall spacers adjacent said gate sidewalls for separating said gate from said source and said drain; and forming contacts to said source, gate and drain to produce a field effect transistor, the improvement comprising:
after forming said first pair of dielectric sidewall spacers, forming a second pair of dielectric sidewall spacers adjacent said first pair to produce sidewalls having reduced steepness as compared with that of said first pair of spacers.

2. The improved method of claim 1 wherein said substrate comprises monocrystalline silicon and said first pair of spacers comprise silicon oxide.

3. The improved method of claim 2 wherein said second pair of spacers comprises silicon oxide.

4. The improved method of claim 2 wherein said second pair of spacers comprise silicon nitride.

5. The improved method of claim 1 wherein said second pair of spacers are formed by depositing a layer of dielectric material over said gate, source and drain and etching back said layer of dielectric material to define said spacers.

6. The improved method of claim 5 wherein said layer of dielectric comprises silicon oxide or silicon nitride.

7. The improved method of claim 5 wherein said etching back is by reactive ion etching or wet chemical etching.

8. A field effect transistor made by the process of claim 1.
